**Europäisches Patentamt**

**European Patent Office**

**Office européen des brevets**

(19)

(11) Veröffentlichungsnummer : **0 467 934 B1**

(12)

# EUROPÄISCHE PATENTSCHRIFT

(45) Veröffentlichungstag der Patentschrift :
04.10.95 Patentblatt 95/40

(51) Int. Cl.⁶ : **H04N 11/12**

(21) Anmeldenummer : **90906160.8**

(22) Anmeldetag : **11.04.90**

(86) Internationale Anmeldenummer :
**PCT/EP90/00575**

(87) Internationale Veröffentlichungsnummer :
**WO 90/13210 01.11.90 Gazette 90/25**

(54) **FARBFERNSEHSYSTEM MIT EINRICHTUNGEN ZUR CODIERUNG UND DECODIERUNG VON FARBFERNSEHSIGNALEN.**

(30) Priorität : **14.04.89 DE 3912323**

(43) Veröffentlichungstag der Anmeldung :
**29.01.92 Patentblatt 92/05**

(45) Bekanntmachung des Hinweises auf die
Patenterteilung :
**04.10.95 Patentblatt 95/40**

(84) Benannte Vertragsstaaten :
**AT BE CH DE DK ES FR GB IT LI LU NL SE**

(56) Entgegenhaltungen :
**Funkschau, Band 60, Nr. 1, 30. Dezember 1988,
(München, DE), M. SILVERBERG:
"Fernsehnormen. Das Bessere Pal", Seiten
46-50**

(73) Patentinhaber : **GRUNDIG E.M.V.
Elektro-Mechanische Versuchsanstalt Max
Grundig GmbH & Co. KG
Kurgartenstrasse 37
D-90762 Fürth (DE)**

(72) Erfinder : **KAYS, Rüdiger
Mooranger 32
D-8501 Schwarzenbruck (DE)**

(74) Vertreter : **Dreykorn-Lindner, Werner,
Dipl.-Ing.
GRUNDIG E.M.V.
Elektro-Mechanische Versuchsanstalt
Max Grundig holländ.Stiftung & Co. KG
Lizenzen und Patente
D-90748 Fürth (DE)**

EP 0 467 934 B1

**Beschreibung**

Die Erfindung betrifft ein Farbfernsehsystem nach dem Oberbegriff des Patentanspruchs 1.

Um bei der Einführung des Farbfernsehsystems die Kompatibilität zu bereits bestehenden Fernsehübertragungssystemen zu gewährleisten und eine Übertragung der Farbinformation innerhalb der vorhandenen Nachrichtenübertragungskanäle mit einer Grenzfrequenz von z.B. 5 MHz zu ermöglichen, wurde das Luminanz- und Chrominanzsignal nach der Technik der Spektrenverkämmung übertragen. Bei der Spektrenverkämmung wurde zwar eine ökonomische Nutzung der Kanalbandbreite erreicht, jedoch treten bei der Decodierung der empfangenen Fernsehsignale Übersprechstörungen auf, die die Bildqualität zum Teil erheblich beeinträchtigen. Durch das Übersprechen des Luminanzsignals in den Chrominanzkanal, wobei diese Übersprechstörung als Cross-Colour bezeichnet wird, entstehen an horizontalen, hochfrequenten Luminanz-Strukturen Übersprechstörungen, welche als rot-grünes bzw. blau-gelbes, wanderndes Wellenmuster erscheinen. Die Übersprechstörung des Chrominanzsignals in den Luminanzkanal, die sogenannte Cross-Luminanz, erscheint als perlschnurartiges, unbuntes Muster in Farbflächen und an Farbkanten. Beide Übersprechstörungen flackern in ruhenden Bildvorlagen mit einer Frequenz von 6,25 Hz und 18,75 Hz.

Zur Reduktion dieser Übersprechstörungen ist aus der Zeitschrift "Radio Mentor", Heft 12, 1969, Seiten 847 bis 851, eine Einrichtung zur Codierung von Farbfernsehsignalen nach der PAL-Norm bekannt, bei der im konventionellen PAL-Coder eine analoge Signalverarbeitung mittels eines im Luminanzkanal angeordneten, abschaltbaren Notch-Filters vorgenommen wird. Durch den Einsatz dieses Notch-Filters kann zwar erreicht werden, daß empfangsseitig bei der Demodulation des Farbträgers Luminanzanteile nicht fälschlicherweise als Chrominanzsignale ausgewertet werden, damit verbunden ist jedoch eine Verringerung der Horizontalauflösung des Luminanzsignals auf einen Wert unterhalb von 4 MHz.

Im Zuge der Weiterentwicklung wurden digitale Signalverarbeitungsverfahren im PAL-Coder untersucht, bei denen die Luminanz- und Chrominanzsignale vor der Zusammenfügung einer Kammfilterung unterzogen wurden. In der dreidimensionalen Spektraldarstellung des Bildes entspricht die Kammfilterung einer zwei- bzw. dreidimensionalen Bandaufteilung die - bei entsprechender digitalen Signalverarbeitung im PAL-Decoder - zu einem Bild mit geringen Übersprechstörungen führen kann.

Aus der Zeitschrift "Fernseh- und Kinotechnik", 39. Jg., Heft 3, 1985, Seiten 123 bis 135, ist ein PAL-Coder und -Decoder bekannt, bei dem eine dreidimensionale Bandbegrenzung von Luminanz- und Chrominanzsignal derart vorgenommen wird, daß Luminanz- und Chrominanzsignal unterschiedliche Frequenzräume belegen. Dieser Lösungsweg wurde beim Gegenstand der nicht vorveröffentlichten, deutschen Patentanmeldung P 38 07 248.3 weiter gegangen, wobei durch eine getrennte dreidimensionale Filterung der Farbdifferenzsignale, jedes dieser Farbdifferenzsignale mit einer optimalen Auflösung übertragen werden kann. Zur Berücksichtigung der augenphysiologischen Gegebenheit des Farbfernsehstandards wurden dabei die Durchlaßbereiche in Richtung vertikaler Ortsfrequenz und Zeitfrequenz der Filter, für die beiden in Richtung der horizontalen Ortsfrequenz bandbegrenzten Farbdifferenzsignale, unterschiedlich gewählt. Bei einem Farbfernsehsignal nach der PAL-Norm kann dadurch berücksichtigt werden, daß das menschliche Auge für Bewegungsverschleifungen bzgl. des Farbdifferenzsignals U wesentlich unempfindlicher ist als für Bewegungsverschleifungen bzgl. des Farbdifferenzsignals V.

Weitere Lösungskonzepte mit dreidimensionaler Filterung im Coder bzw. Decoder sind in der Zeitschrift "Fernseh- und Kino-Technik", 42. Jg., Nr. 9, 1988, Seiten 403 bis 422, bzw. in der Zeitschrift "Funkschau", Nr. 1, 1989, Seiten 46 bis 50, ausführlich erläutert.

Allen vorgenannten Lösungskonzepten ist gemeinsam, daß ein hoher Schaltungsaufwand im Coder bzw. Decoder erforderlich ist, um die Übersprechstörungen zu beseitigen und daß damit ein Verlust an Detailauflösung, d.h. verringerte Auflösung für Luminanz und Chrominanz, verbunden ist.

Der Erfindung liegt die Aufgabe zugrunde, ein Farbfernsehsystem derart auszugestalten, daß eine völlig übersprechfreie Übertragung hochfrequenter Luminanz- und Chrominanzsignale mit einer höheren Auflösung ermöglicht wird.

Diese Aufgabe wird bei einem gattungsgemäßen Farbfernsehsystem durch die kennzeichnenden Merkmale des Patentanspruchs 1 gelöst.

Dem erfindungsgemäßen Farbfernsehsystem liegt die Erkenntnis zugrunde, daß unter Berücksichtigung augenphysiologischer Aspekte eine zeitliche Auflösung für Chrominanzsignal und höherfrequentes Luminanzsignal (z.B. ab etwa 3,5 MHz) von 12,5 Hz, d.h. eine Bildwiederholfrequenz von 25 Hz ausreichend ist. Bei Filmmaterial ist ohnehin keine höhere zeitliche Auflösung gegeben. Insbesondere für Filmmaterial wird beim erfindungsgemäßen Farbfernsehsystem eine völlig übersprechfreie Übertragung hochfrequenter Luminanz- und Chrominanzsignale mit hoher Auflösung ermöglicht. Die erhöhte Auflösung ist darauf zurückzuführen, daß die bei den obengenannten Konzepten erforderliche Filterung in Richtung vertikaler Ortsfrequenz bzw. Zeitfrequenz entfallen kann. Der in der Einrichtung zur Codierung bzw. Decodierung erforderliche

EP 0 467 934 B1

Schaltungsaufwand ist wesentlich geringer, da nur je ein Halbbildspeicher für Luminanzsignal und die beiden Farbdifferenzsignale benötigt wird. Beim erfindungsgemäßen Farbfernsehsystem können beliebige Modulationsverfahren eingesetzt werden und es ist kompatibel zu konventionellen Fernsehempfängern, welche nach der PAL-Fernsehnorm, NTSC-Fernsehnorm oder SECAM-Fernsehnorm arbeiten. Weiterhin weist das erfindungsgemäße Farbfernsehsystem den Vorteil auf, daß in den Fernsehempfängern, welche die Einrichtung zur Decodierung enthalten, eine Rauschreduktion um 3 dB für Chrominanzsignal und hochfrequentes Luminanzsignal erzielt wird.

Bei der Ausführungsform des Farbfernsehsystems nach Anspruch 10 und 11 wird sende- und empfangsseitig eine dreidimensionale Filterung vorgenommen. Dadurch können Aliasfehler (Bewegungsrucken) vermieden werden, wenn elektronisch produziertes Material gesendet wird.

Bei den Ausführungsformen des Farbfernsehsystems nach den Ansprüchen 12 bis 14 ist die dreidimensionale Filterung in der Einrichtung zur Codierung und/oder in der Einrichtung zur Decodierung in Abhängigkeit von der Bildwiederholfrequenz abschaltbar. Die sendeseitige Abschaltung bzw. Umsteuerung kann in Abhängigkeit vom gesendeten Material, d.h. Filmmaterial oder elektronisch produziertem Material, vorgenommen werden. Zur Ermittlung der Bewegungsphase von erstem und zweitem Halbbild kann beispielsweise im Fernsehempfänger ein Bewegungsdetektor angeordnet sein, welcher ein Steuersignal zur Umsteuerung erzeugt oder die Umsteuerung erfolgt durch empfängerseitige Auswertung eines sendeseitig erzeugten Steuersignals, welches beispielsweise in der Datenzeile des Fernsehsignals übertragen wird. Das sendeseitige Steuersignal kann mit anderen sendeseitigen Steuerungsmaßnahmen kombiniert werden, beispielsweise mit einer Bildformatänderung, mit einer Umsteuerung zwischen verschiedenen Flimmerreduktionsverfahren, je nachdem ob Filmmaterial oder elektronisch produziertes Material gesendet wird, usw..

Die Ausführungsform des Farbfernsehsystems nach Anspruch 15 weist den Vorteil auf, daß beim konventionellen Farbfernsehempfänger die Cross-Colour-Störungen um den gewählten Absenkungsfaktor reduziert werden.

Die Erfindung wird im folgenden anhand in der Zeichnung dargestellter Ausführungsformen näher beschrieben und erläutert.

Es zeigt:

Fig. 1      das Blockschaltbild einer Ausführungsform der erfindungsgemäßen Einrichtung zur Codierung,

Fig. 2      das Blockschaltbild einer Ausführungsform der erfindungsgemäßen Einrichtung zur Decodierung,

Fig. 3      das Blockschaltbild einer zweiten Ausführungsform der erfindungsgemäßen Einrichtung zur Decodierung,

Fig. 4      das Speichernutzungsschema für die Ausführungsform nach Fig. 3

Fig. 5      schematisch die Zeilenzählung zur Erläuterung der Definition des Farbträgers.

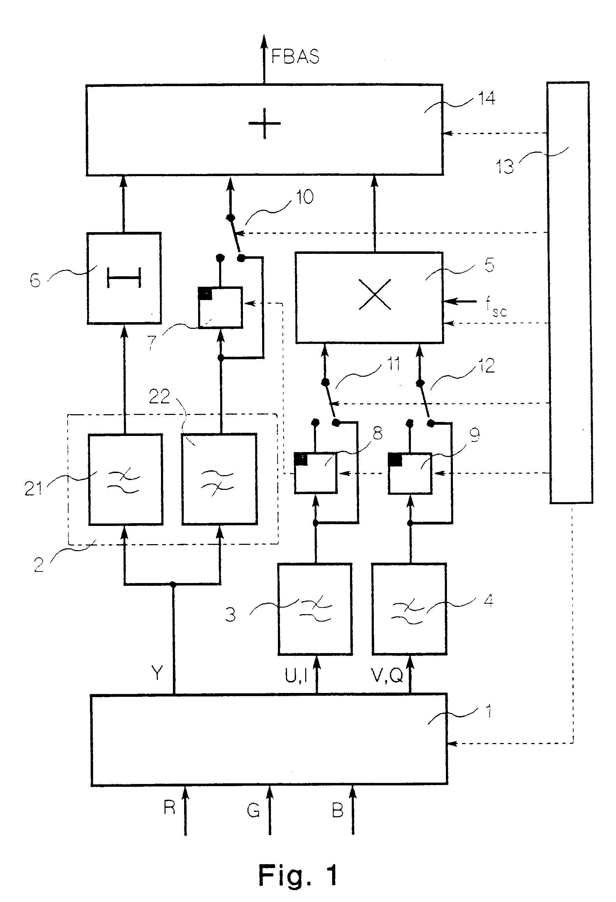

Fig. 1 zeigt das Blockschaltbild einer Ausführungsform der erfindungsgemäßen Einrichtung zur Codierung. In an sich bekannter Weise enthält diese Einrichtung:

- eine Matrixschaltung 1 zur Umwandlung von RGB-Eingangssignalen in ein Luminanzsignal Y und mindestens zwei Farbdifferenzsignale U, V; I, Q,
- eine Filterschaltung 2 und eine mit dieser verbundene Laufzeitausgleichsschaltung 6 im Luminanzkanal,
- eine Filterschaltung 3, 4 für die Farbdifferenzsignale U, V; I, Q,
- einen Modulator 5 zur Umwandlung der Farbdifferenzsignale U, V; I, Q am Ausgang der Filterschaltung 3, 4 in ein Chrominanzsignal und
- eine Additionsschaltung 14 zum Zusammenfassen von Luminanzsignal am Ausgang der Laufzeitausgleichsschaltung 6 und Chrominanzsignal zum Farbfernsehsignal FBAS.

Erfindungsgemäß wird in der Einrichtung zur Codierung eine zeitliche Unterabtastung von Chrominanzsignal und hochfrequentem Luminanzsignal derart vorgenommen, daß für erstes und zweites Halbbild jeweils die unmodulierten Farbdifferenzsignale U, V; I, Q und das hochfrequente Luminanzsignal gleich sind. Hierzu wird das hochfrequente Luminanzsignal und die Farbdifferenzsignale U, V; I, Q jeweils einem Halbbildspeicher 7, 8, 9 und einer Umschalteeinrichtung 10, 11, 12 zugeführt, deren Steuereingang mit einer Steuereinrichtung 13 und deren weiterer Eingang mit dem Halbbildspeicher 7, 8, 9 verbunden ist. Der Ausgang der Umschalteeinrichtung 10 ist an die Additionsschaltung 14 und der Ausgang der Umschalteeinrichtungen 11 und 12 ist jeweils an den Modulator 5 angeschlossen.

Die in der Einrichtung zur Codierung angeordnete Filterschaltung 2 besteht aus einem Tiefpaß 21, welcher mit der Laufzeitausgleichsschaltung 6 verbunden ist, und einem Hochpaß 22. Über die in der Zeichnung strichliniert dargestellten Steuerleitungen werden der Einlese- und Auslesevorgang des Halbbildspeichers 34, 39, 43 und der Umschaltevorgang der Umschalteeinrichtung 37, 42, 46 von der Steuereinrichtung 13 gesteuert.

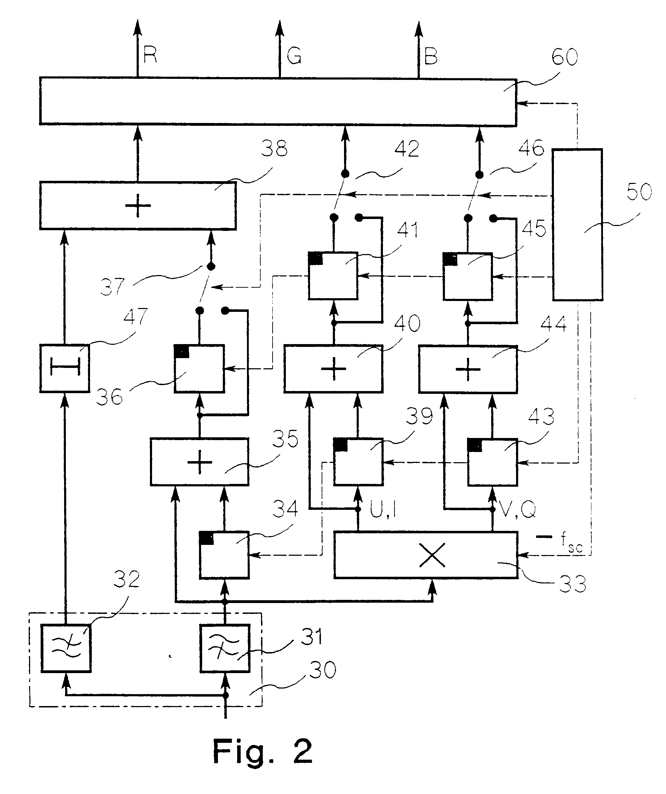

Fig. 2 zeigt das Blockschaltbild einer ersten Ausführungsform der erfindungsgemäßen Einrichtung zur Decodierung von Farbfernsehsignalen FBAS. In an sich bekannter Weise enthält diese Einrichtung:

EP 0 467 934 B1

- eine Filterschaltung 30 zur Trennung des Farbfernsehsignals FBAS in hochfrequente und niederfrequente Signalanteile (d.h. Luminanz-/Chrominanz-Signaltrennung beim Stand der Technik),
- einen Demodulator 33 zur Umwandlung des Chrominanzsignals in zwei Farbdifferenzsignale U, V; I, Q
- eine im Luminanzkanal angeordnete Laufzeitausgleichsschaltung 47 und
- eine Dematrixschaltung 60 zur Umwandlung des Luminanzsignals Y und der zwei Farbdifferenzsignale U, V; I, Q in RGB-Ausgangssignale.

Erfindungsgemäß werden vom empfangenen ersten und zweiten Halbbild einerseits - zur Beseitigung von Cross-Luminanz - die hochfrequenten Signalanteile des Farbfernsehsignals FBAS und andererseits - zur Beseitigung von Cross-Colour - die demodulierten, niederfrequenten Farbdifferenzsignale U, V; I, Q addiert. Hierzu werden die hochfrequenten Signalanteile des Farbfernsehsignals FBAS und die demodulierten, niederfrequenten Farbdifferenzsignale U, V; I, Q jeweils einem Halbbildspeicher 34, 39, 43 und einem ersten Eingang einer Addierschaltung 35, 40, 44 zugeführt, deren zweiter Eingang mit dem Ausgang des Halbbildspeichers 34, 39, 43 verbunden ist. Der Ausgang der Addierschaltung 35, 30, 44 ist sowohl mit einem weiteren Halbbildspeicher 36, 41, 45 als auch mit einer Umschalteeinrichtung 37, 42, 46 verbunden, deren Steuereingang mit einer Steuereinrichtung 50 und deren weiterer Eingang mit dem zweiten Halbbildspeicher 36, 41, 45 verbunden ist.

Die in der Einrichtung zur Decodierung angeordnete Filterschaltung 30 besteht aus einem Tiefpaß 32, welcher mit der Laufzeitausgleichsschaltung 47 verbunden ist, und einem Hochpaß 31. Die Laufzeitausgleichsschaltung 47 ist mit einem ersten Eingang einer Verknüpfungsschaltung 38 verbunden, deren Ausgangssignal der Dematrixschaltung 60 zugeführt wird und deren zweiter Eingang am Ausgang der im Luminanzkanal liegenden Umschalteeinrichtung 37 angeschlossen ist. Der Ausgang der im Chrominanzkanal liegenden Umschalteeinrichtung 42 und 46 ist an die Dematrixschaltung 60 angeschlossen.

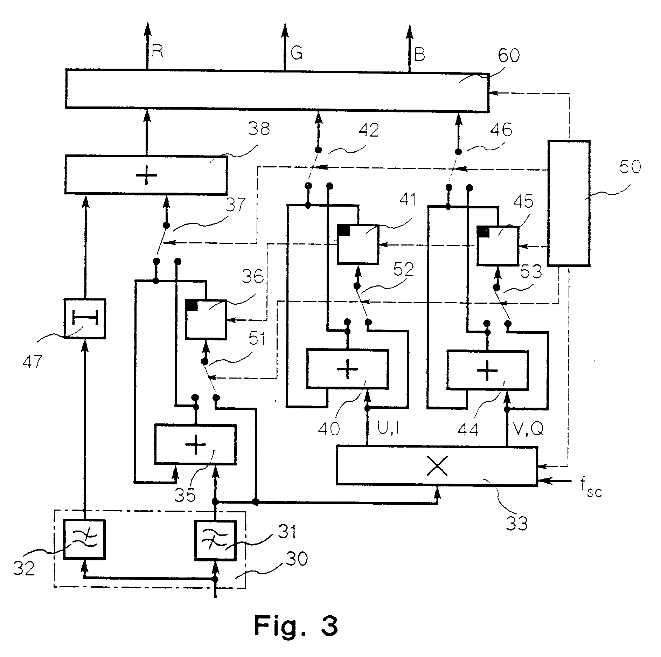

Bei der in Fig. 3 dargestellten zweiten Ausführungsform der Einrichtung zur Decodierung ist der Speicheraufwand reduziert. Hierzu werden die hochfrequenten Signalanteile des Farbfernsehsignals FBAS und die demodulierten, niederfrequenten Farbdifferenzsignale U, V; I, Q jeweils einem ersten Eingang der Addierschaltung 35, 40, 44 und einer ersten Umschalteeinrichtung 51, 52, 53 zugeführt. Der Ausgang der Addierschaltung 35, 40, 44 ist mit einem ersten Eingang einer zweiten Umschalteeinrichtung 37, 42, 46 verbunden, wobei diese den in Fig. 2 dargestellten Umschalteeinrichtungen 37, 42 46 entsprechen. Am Ausgang der ersten Umschalteeinrichtung 51, 52, 53 ist ein Halbbildspeicher 36, 41, 45 (entsprechend zu Fig. 2) angeschlossen und der Ausgang des Halbbildspeichers 36, 41, 45 ist sowohl mit einem zweiten Eingang der Addierschaltung 35, 40, 44 als auch mit einem zweiten Eingang der zweiten Umschalteeinrichtung 37, 42, 46 verbunden. Am Ausgang der im Chrominanzkanal liegenden zweiten Umschalteeinrichtung 42, 46 ist die Dematrixschaltung 60 angeschlossen. Die Steuersignale für den Einlese- und Auslesevorgang bzw. Umschaltevorgang werden den Halbbildspeichern 36, 41, 45 bzw. ersten und zweiten Umschalteeinrichtung 51, 52, 53 bzw. 37, 42, 46 über die in der Zeichnung strichliniert dargestellten Steuerleitungen zugeführt.

Die Funktionsweise der erfindungsgemäßen Einrichtungen zur Codierung und Decodierung von Farbfernsehsignalen wird im folgenden näher beschrieben und erläutert, wobei vom PAL-Farbfernsehverfahren und von folgenden Vereinfachungen und Definitionen ausgegangen wird:

1. Es erfolgt nur eine Intraframe-Verarbeitung, so daß die Beschreibung in der XY-Ebene ausreichend ist. Die Signale werden als Funktion des Ortes x und der Zeilennummer n dargestellt.

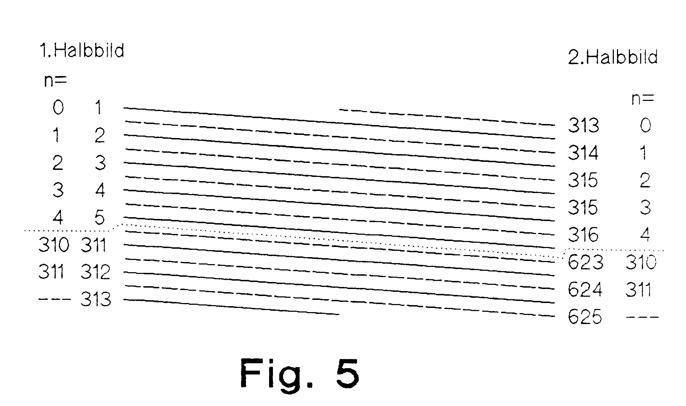

2. Fig. 5 zeigt die Zeilen eines Vollbildes. Für eine einfache Beschreibung werden den Zeilen (sowohl des ersten als auch des zweiten Halbbildes) Indexzahlen n gegeben, wobei gilt:

a) Die erste Zeile des ersten Halbbildes hat die Nummer n = 0

b) Eine Zeile $n_1$ des zweiten Halbbildes liegt geometrisch um eine Vollbildzeilenbreite d oberhalb der Zeile $n_1$ des ersten Halbbildes.

3. Für den Farbträger gilt:

1. Halbbild:

$$f_{scu}(x,n) = \sin\left(\varphi_x - \frac{n\pi}{2}\right)$$

Viertelzeilenoffset

$$f_{scv}(x,n) = \cos\left(\varphi_x - \frac{n\pi}{2}\right) \cdot (-1)^n = \cos\left(\varphi_x + \frac{n\pi}{2}\right)$$

PAL

2. Halbbild:

$$f_{scu}(x,n) = \sin\left(\varphi_x - \frac{n\pi}{2} + \pi\right) = -\sin\left(\varphi_x - \frac{n\pi}{2}\right)$$

Halbbildoffset

4

$$f_{scv}(x,n) = \cos\left(\varphi_x + \frac{n\pi}{2} + \pi\right) = -\cos\left(\varphi_x + \frac{n\pi}{2}\right)$$

Bei dieser Betrachtung wird der 25 Hz-Versatz des Farbträgers innerhalb eines Halbbildes vernachlässigt, der Halbbild-Offset wird jedoch berücksichtigt. Dies vereinfacht die Darstellung und bewirkt keine störenden Rechenfehler, solange keine Filterung in Richtung vertikaler Ortsfrequenz mit extrem großer Filterlänge vorgenommen wird. Diese Bedingung ist in der Praxis meist erfüllt.

Nach der Matrixschaltung 1 liegen die Signale $y(x,n)$, $u(x,n)$ und $v(x,n)$ an, d.h. im ersten Halbbild $y_1(x,n)$, $u_1(x,n)$ und $v_1(x,n)$ und im zweiten Halbbild $y_2(x,n)$, $u_2(x,n)$, $v_2(x,n)$.

Durch das Tiefpaßfilter 21 werden die niederfrequenten Luminanzteile zur Additionsschaltung 14 durchgelassen. Die Grenzfrequenz des Tiefpaß 21 liegt zwischen 3 und 3,5 MHz, wodurch alle Komponenten durchgelassen werden, für die keine Überschneidungen mit dem Chrominanzsignal auftreten. Die Grenzfrequenz hängt deshalb mit der Bandbreite der Filterschaltung 3, 4 zusammen. Der Hochpaß 22 hat einen zum Tiefpaß 21 komplementären Frequenzgang. Es kann noch eine Absenkung des hochfrequenten Luminanzsignals $y_{1H}(x,n)$ erfolgen (Faktor $c_1$), um im kompatiblen Empfänger eine Cross-Colour-Reduktion zu erzielen (ähnlich der teilweise gebräuchlichen Notchfilterung).

Die Anordnung aus Halbbildspeicher 7 und Umschalteeinrichtung 10 bewirkt, daß die hochfrequente Luminanzinformation in beiden Halbbildern gleich ist. Im ersten Halbbild wird $y_{1H}(x,n)$ an die Additionsschaltung 14 gegeben. Die Umschalteeinrichtung 10 ist in der in Fig. 1 gezeichneten Stellung.

Während das zweite Halbbild anliegt, ist die Umschalteeinrichtung 10 in der anderen Stellung, wodurch das um $T_o$ verzögerte Signal weitergegeben wird. Für die Verzögerung ist im PAL-Standard $T_o = 312 \times 64$ µs zu wählen, damit liegt am Ausgang wieder $y_{1H}(x,n)$ an.

Die gleiche Anordnung aus Halbbildspeicher und Umschalteeinrichtung wird auch im Chrominanzkanal eingesetzt. Am Eingang des Modulators 5 liegt dann sowohl im ersten wie auch im zweiten Halbbild das Signal $u_1(x,n)$ bzw. $v_1(x,n)$ an.

Nach Modulation erhält man entsprechend obiger Beschreibung des Farbträgers:
im 1. Halbbild

$$u_1(x,n) \cdot \sin\left(\varphi_x - \frac{n\pi}{2}\right) + v_1(x,n) \cdot \cos\left(\varphi_x + \frac{n\pi}{2}\right)$$

im 2. Halbbild

$$- u_1(x,n) \cdot \sin\left(\varphi_x - \frac{n\pi}{2}\right) - v_1(x,n) \cdot \cos\left(\varphi_x + \frac{n\pi}{2}\right)$$

Bezeichnet man mit $y_T(x,n)$ die Tiefpaßkomponente der Luminanz und mit $y_H(x,n)$ die Hochpaßkomponente, so erhält man als FBAS-Signal auf dem Übertragungskanal:
1. Halbbild:

$$f_1(x,n) = y_{T1}(x,n) + c_1 \cdot y_{H1}(x,n) + u_1(x,n) \cdot \sin\left(\varphi_x - \frac{n\pi}{2}\right) + v_1(x,n) \cdot \cos\left(\varphi_x + \frac{n\pi}{2}\right)$$

2. Halbbild:

$$f_2(x,n) = y_{T2}(x,n) + c_1 \cdot y_{H1}(x,n) - u_1(x,n) \cdot \sin\left(\varphi_x - \frac{n\pi}{2}\right) - v_1(x,n) \cdot \cos\left(\varphi_x + \frac{n\pi}{2}\right)$$

Insgesamt wird je ein Halbbildspeicher für $Y_H$, U und V benötigt, wobei erfindungsgemäß für Chrominanzsignal und hochfrequentes Luminanzsignal eine zeitliche Unterabtastung in der Einrichtung zur Codierung erfolgt.

Prinzipiell besteht daher die Gefahr von zeitlichen Aliasfehlern (Rucken wie beim Kinofilm). Es ist zu erwarten, daß hierdurch keine Qualitätseinbußen entstehen. Gegebenenfalls könnte in einer aufwendigeren Einrichtung zur Codierung eine zeitliche Vorfilterung erfolgen, bevor eine Unterabtastung durchgeführt wird.

Zur Decodierung im Luminanzkanal trennt der Tiefpaß 32 wieder die niederfrequenten Luminanzanteile ab, die über die Laufzeitausgleichsschaltung 47 der Verknüpfungsschaltung 38 zugeführt werden. Die Laufzeit ist im Decoder etwa 20ms entsprechend der Dauer eines Halbbildes.

Der zum Tiefpaß 32 komplementäre Hochpaß 31 liefert an seinem Ausgang ein Signalgemisch aus hochfrequenter Luminanz und modulierter Chrominanz.

Die Luminanzabtrennung der hochfrequenten Luminanzanteile erfolgt nun durch die Schaltungsanordnung aus Addierschaltung 35, Halbbildspeicher 36 und den Umschalteeinrichtungen 37, 51. Eine entsprechende Schaltungsanordnung wird auch im Chrominanzkanal benutzt.

Während das erste Halbbild angeliefert wird, sind beide Umschalteeinrichtungen 37, 51 in der in Fig. 3 gezeichneten Stellung. Am Eingang des Halbbildspeichers 36 liegt damit das Signal des ersten Halbbildes an. Der Halbbildspeicher 36 wird nun so gesteuert, daß vor dem Einschreiben in eine Speicherstelle zunächst der alte Bildinhalt ausgelesen wird. In diesem Fall ist dort noch die Information des vorherigen Vollbildes, nämlich die Summe der beiden Halbbilder, abgelegt. Diese Information wird, ggf. mit einem Faktor $c_2 = 0,5 c_1$ gewichtet,

an die Verknüpfungsschaltung 38 geführt.

Liegt das zweite Halbbild an, so erfolgt eine Umschaltung. Am Ausgang der Addierschaltung 35 liegt dann die Summe aus der Information des ersten Halbbildes und zweiten Halbbildes an.

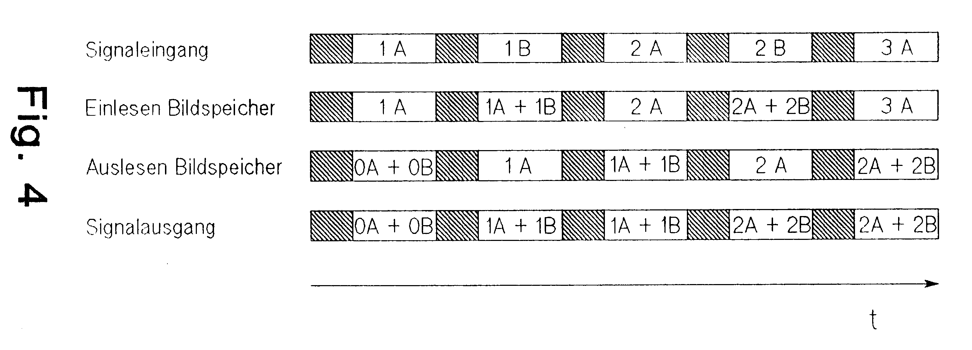

Während des ersten Halbbildes des darauf folgenden Vollbildes wird diese Summeninformation nochmals ausgelesen. Die Anordnung verzögert also das Signal um 20ms. Diese Funktionsweise ist auch aus der Fig. 4 (Speichernutzungsschema) ersichtlich.

Am Ausgang der Anordnung erhält man demnach immer die Summe der Informationen zweier zusammengehörender Halbbilder:

$$\varphi'_H(x,n) = c_1 \cdot \varphi_{H1}(x,n) + u_1(x,n) \cdot \sin(\varphi_x - \frac{n\pi}{2}) + v_1(x,n) \cdot \cos(\varphi_x + \frac{n\pi}{2}) + c_1 \cdot \varphi_{H1}(x,n) - u_1(x,n) \cdot \sin(\varphi_x - \frac{n\pi}{2}) - v_1(x,n) \cdot \cos(\varphi_x + \frac{n\pi}{2})$$

$$= 2c_1 \cdot \varphi_{H1}(x,n)$$

Das Summensignal $y'_H(x,n)$ ist frei von Cross-Colour-Störungen. Es ist noch eine Amplitudengewichtung mit dem Faktor $c_2 = 0{,}5c_1$ erforderlich. Durch die Addition erfolgt eine Rauschreduktion um 3 dB. Es ist deshalb akzeptabel, die hochfrequenten Luminanzanteile mit $c_1 < 1$ im Sender abzusenken, um dem kompatiblen Empfänger eine Cross-Colour-Reduktion zu bieten.

Zur Farbdecodierung werden die hochfrequenten FBAS-Anteile zunächst dem Demodulator 33 zugeführt, der das Signal mit den rekonstruierten Farbträgern multipliziert und eine Tiefpaßfilterung durchführt:

1. Halbbild:

$$u'(x,n) = \left\{ c_1 \, y_{H1}(x,n) \cdot \sin\left(\varphi_x - \frac{n\pi}{2}\right) + u_1(x,n) \cdot \sin^2\left(\varphi_x - \frac{n\pi}{2}\right) + v_1(x,n) \cdot \sin\left(\varphi_x - \frac{n\pi}{2}\right) \cdot \cos\left(\varphi_x + \frac{n\pi}{2}\right) \right\}_{TP}$$

$$= c_1 \, y_{H1}(x,n) \cdot \sin\left(\varphi_x - \frac{n\pi}{2}\right) + \frac{1}{2} \cdot u_1(x,n)$$

Die dabei entstehende doppelte Farbträgerfrequenz -gemäß $\cos(2\varphi_x - n\pi)$ bzw. $\sin(2\varphi_x)$- wird vom Tiefpaß unterdrückt.

2. Halbbild:

$$u'(x,n) = \left\{ -c_1 \, y_{H1}(x,n) \cdot \sin\left(\varphi_x - \frac{n\pi}{2}\right) + u_1(x,n) \cdot \sin^2\left(\varphi_x - \frac{n\pi}{2}\right) + v_1(x,n) \cdot \sin\left(\varphi_x - \frac{n\pi}{2}\right) \cdot \cos\left(\varphi_x + \frac{n\pi}{2}\right) \right\}_{TP}$$

$$= -c_1 \, y_{H1}(x,n) \cdot \sin\left(\varphi_x - \frac{n\pi}{2}\right) + \frac{1}{2} \, u_1(x,n)$$

Durch Addition der beiden Halbbildanteile:

$$u'(x,n) = u_1(x,n)$$

Man erhält daher die U-Komponente völlig frei von Cross-Luminanz-Störungen. Die gleichen Überlegungen sind auch für die V-Komponenten durchzuführen. Die decodierten Signale können dann der Dematrixschaltung 60 zugeführt werden.

Wie die vorstehenden Ausführungen zeigen, können im erfindungsgemäßen Farbfernsehsystem beliebige Modulationsverfahren (Quadraturmodulation, Frequenzmodulation) eingesetzt werden und es wird mit geringem Schaltungsaufwand eine völlig übersprechfreie Übertragung (bei Filmmaterial) hochfrequenter Luminanz- und Chrominanzsignale mit hoher Auflösung ermöglicht.

**Patentansprüche**

1. Farbfernsehsystem mit einer Einrichtung zur Codierung von Farbfernsehsignalen, welche aufweist:
   - eine Matrixschaltung (1) zur Umwandlung von RGB-Eingangssignalen in ein Luminanzsignal (Y) und mindestens zwei Farbdifferenzsignale (U, V, I, Q),
   - eine Filterschaltung (2) und eine mit dieser verbundene Laufzeitausgleichsschaltung (6) im Luminanzkanal,
   - eine Filterschaltung (3, 4) für die Farbdifferenzsignale (U, V, I, Q),
   - einen Modulator (5) zur Umwandlung der Farbdifferenzsignale (U, V, I, Q) am Ausgang der Filterschaltung (3, 4) in ein Chrominanzsignal und
   - eine Additionsschaltung (14) zum Zusammenfassen von Luminanzsignal am Ausgang der Laufzeitausgleichsschaltung (6) und Chrominanzsignal zum Farbfernsehsignal (FBAS),

   und mit einer Einrichtung zur Decodierung von Farbfernsehsignalen, welche aufweist:
   - eine Filterschaltung (30) zur Trennung des Farbfernsehsignals (FBAS) in hochfrequente und niederfrequente Signalanteile,
   - einen Demodulator (33) zur Umwandlung des Chrominanzsignals in zwei Farbdifferenzsignale (U, V, I, Q),
   - eine im Luminanzkanal angeordnete Laufzeitausgleichsschaltung (47) und
   - eine Dematrixschaltung (60) zur Umwandlung des Luminanzsignals (Y) und der zwei Farbdifferenzsignale (U, V, I, Q) in RGB-Ausgangssignale,

   **dadurch gekennzeichnet**, daß

   die Einrichtung zur Codierung derart ausgebildet ist, daß eine zeitliche Unterabtastung von Chrominanzsignal und hochfrequentem Luminanzsignal derart vorgenommen wird, daß für erstes und zweites Halbbild jeweils die unmodulierten Farbdifferenzsignale (U, V; I, Q) und das hochfrequente Luminanzsignal gleich sind, und daß die Einrichtung zur Decodierung derart ausgebildet ist, daß zur Beseitigung von Cross-Luminanz vom empfangenen ersten und zweiten Halbbild die hochfrequenten Signalanteile des Farbfernsehsignals (FBAS), welche sowohl das hochfrequente Luminanzsignal als auch das Chrominanzsignal enthalten, addiert werden und daß zur Beseitigung von Cross-Colour vom empfangenen ersten und zweiten Halbbild die demodulierten, niederfrequenten Farbdifferenzsignale (U, V; I, Q) addiert werden.

2. Farbfernsehsystem nach Anspruch 1, **dadurch gekennzeichnet**, daß in der Einrichtung zur Codierung das hochfrequente Luminanzsignal und die Farbdifferenzsignale (U, V; I, Q) jeweils einem Halbbildspeicher (7, 8, 9) und einer Umschalteeinrichtung (10, 11, 12) zugeführt werden, deren Steuereingang mit einer Steuereinrichtung (13) und deren weiterer Eingang mit dem Halbbildspeicher (7, 8, 9) verbunden ist.

3. Farbfernsehsystem nach Anspruch 1, **dadurch gekennzeichnet**, daß in der Einrichtung zur Decodierung die hochfrequenten Signalanteile des Farbfernsehsignals (FBAS) und die demodulierten, niederfrequenten Farbdifferenzsignale (U, V; I, Q) jeweils einem Halbbildspeicher (34, 39, 43) und einem ersten Eingang einer Addierschaltung (35, 40, 44) zugeführt werden, deren zweiter Eingang mit dem Ausgang des Halbbildspeichers (34, 39, 43) verbunden ist und daß der Ausgang der Addierschaltung (35, 30, 44) sowohl mit einem weiteren Halbbildspeicher (36, 41, 45) als auch mit einer Umschalteeinrichtung (37, 42, 46) verbunden ist, deren Steuereingang mit einer Steuereinrichtung (50) und deren weiterer Eingang mit dem zweiten Halbbildspeicher (36, 41, 45) verbunden ist.

4. Farbfernsehsystem nach Anspruch 1, **dadurch gekennzeichnet**, daß die in der Einrichtung zur Codierung angeordnete Filterschaltung (2) besteht aus einem Tiefpaß (21), welcher mit der Laufzeitausgleichsschaltung (6) verbunden ist, und einem Hochpaß (22).

5. Farbfernsehsystem nach Anspruch 1, **dadurch gekennzeichnet**, daß die in der Einrichtung zur Decodierung angeordnete Filterschaltung (30) aus einem Tiefpaß (32), welcher mit der Laufzeitausgleichsschaltung (47) verbunden ist, und einem Hochpaß (31) besteht.

6. Farbfernsehsystem nach Anspruch 2, **dadurch gekennzeichnet**, daß die Laufzeitausgleichsschaltung (47) mit einem ersten Eingang einer Verknüpfungsschaltung (38) verbunden ist, deren Ausgangssignal der Dematrixschaltung (60) zugeführt wird und deren zweiter Eingang am Ausgang der im Luminanzkanal liegenden Umschalteeinrichtung (37) angeschlossen ist.

7. Farbfernsehsystem nach Anspruch 1, **dadurch gekennzeichnet**, daß in der Einrichtung zur Decodierung die hochfrequenten Signalanteile des Farbfernsehsignals (FBAS) und die demodulierten, niederfrequenten Farbdifferenzsignale (U, V; I, Q) jeweils einem ersten Eingang einer Addierschaltung (35, 40, 44) und einer ersten Umschalteeinrichtung (51, 52, 53) zugeführt werden, daß der Ausgang der Addierschaltung (35, 40, 44) mit einem ersten Eingang einer zweiten Umschalteeinrichtung (37, 42, 46) verbunden ist, daß am Ausgang der ersten Umschalteeinrichtung (51, 52, 53) ein Halbbildspeicher (36, 41, 45) angeschlossen ist und daß der Ausgang des Halbbildspeichers (36, 41, 45) sowohl mit einem zweiten Eingang der Addierschaltung (35, 40, 44) als auch mit einem zweiten Eingang der zweiten Umschalteeinrichtung (37, 42, 46) verbunden ist.

8. Farbfernsehsystem nach Anspruch 1, **dadurch gekennzeichnet**, daß als Einrichtung zur Decodierung ein an sich bekannter PAL-Decoder benutzt wird.

9. Farbfernsehsystem nach Anspruch 1, **dadurch gekennzeichnet**, daß als Einrichtung zur Codierung ein an sich bekannter PAL-Coder benutzt wird.

10. Farbfernsehsystem nach Anspruch 1, **dadurch gekennzeichnet**, daß in der Einrichtung zur Codierung das hochfrequente Luminanzsignal und/oder das Chrominanzsignal einer Filterung in Richtung horizontaler Ortsfrequenz oder in Richtung vertikaler Ortsfrequenz oder in Richtung der Zeitfrequenz und/oder Kombinationen hiervon unterzogen wird.

11. Farbfernsehsystem nach Anspruch 1, **dadurch gekennzeichnet**, daß in der Einrichtung zur Decodierung die demodulierten, niederfrequenten Farbdifferenzsignale (U, V; I, Q) einer Filterung in Richtung horizontaler Ortsfrequenz oder in Richtung vertikaler Ortsfrequenz oder in Richtung der Zeitfrequenz und/oder Kombinationen hiervon unterzogen werden.

12. Farbfernsehsystem nach Anspruch 10 und 11, **dadurch gekennzeichnet**, daß die Filterungen in der Einrichtung zur Codierung und/oder in der Einrichtung zur Decodierung in Abhängigkeit von der Bildwiederholfrequenz abschaltbar ist.

13. Farbfernsehsystem nach Anspruch 1, **dadurch gekennzeichnet**, daß in Abhängigkeit der von einem Bewegungsdetektor ermittelten Bewegungsphase zwischen erstem und zweitem Halbbild eine Umsteuerung zwischen der Einrichtung zur Codierung und einem an sich bekannten PAL-Coder vorgenommen wird.

14. Farbfernsehsystem nach Anspruch 13, **dadurch gekennzeichnet**, daß sendeseitig bei der Umsteuerung ein Steuersignal erzeugt wird, welches empfangsseitig ausgewertet wird.

15. Farbfernsehsystem nach Anspruch 1, **dadurch gekennzeichnet**, daß in der Einrichtung zur Codierung die hochfrequente Luminanzinformation abgesenkt wird und daß in der Einrichtung zur Decodierung die hochfrequente Luminanzinformation wieder angehoben wird.

**Claims**

1. Colour television system comprising a device for coding colour television signals which exhibits:
   - a matrix circuit (1) for converting RGB input signals into a luminance signal (Y) and at least two colour difference signals (U, V, I, Q),
   - a filter circuit (2) and a delay equalising circuit (6), connected to the latter, in the luminance channel,
   - a filter circuit (3, 4) for the colour difference signals (U, V, I, Q),
   - a modulator (5) for converting the colour difference signals (U, V, I, Q) at the output of the filter circuit (3, 4) into a chrominance signal and
   - an addition circuit (14) for combining luminance signal at the output of the delay equalising circuit (6) and chrominance signal to form the colour television signal (FBAS),
   and comprising a device for decoding colour television signals which exhibits:
   - a filter circuit (30) for separating the colour television signal (FBAS) into high-frequency and low-frequency signal components,
   - a demodulator (33) for converting the chrominance signal into two colour difference signals (U, V, I, Q),
- a delay equalising circuit (47) arranged in the luminance channel, and
- a dematrix circuit (60) for converting the luminance signal (Y) and the two colour difference signals (U, V, I, Q) into RGB output signals,
characterised in that the device for coding is designed in such a manner that a temporal sub-Nyquist sampling of chrominance signal and high-frequency luminance signal is carried out in such a manner that in each case the unmodulated colour difference signals (U, V; I, Q) and the high-frequency luminance signal are identical for the first and second field, and in that the device for decoding is designed in such a manner that the high-frequency signal components of the colour television signal (FBAS), which contain both the high-frequency luminance signal and the chrominance signal, are added for eliminating cross-luminance of the received first and second field, and in that the demodulated low-frequency colour difference signals (U, V; I, Q) are added for eliminating cross-colour of the received first and second field.

2. Colour television system according to Claim 1, characterised in that in the device for coding, the high-frequency luminance signal and the colour difference signals (U, V; I, Q) are in each case supplied to a field buffer (7, 8, 9) and to a changeover device (10, 11, 12), the control input of which is connected to a control device (13) and the further input of which is connected to the field buffer (7, 8, 9).

3. Colour television system according to Claim 1, characterised in that in the device for decoding, the high-frequency signal components of the colour television signal (FBAS) and the demodulated low-frequency colour difference signals (U, V; I, Q) are in each case supplied to a field buffer (34, 39, 43) and to a first input of an adding circuit (35, 40, 44), the second input of which is connected to the output of the field buffer (34, 39, 43) and in that the output of the adding circuit (35, 30, 44) is connected both to a further field buffer (36, 41, 45) and to a changeover device (37, 42, 46), the control input of which is connected to a control device (50) and the further input of which is connected to the second field buffer (36, 41, 45).

4. Colour television system according to Claim 1, characterised in that the filter circuit (2) arranged in the device for coding consists of a low-pass filter (21), which is connected to the delay equalising circuit (6), and of a high-pass filter (22).

5. Colour television system according to Claim 1, characterised in that the filter circuit (30) arranged in the device for decoding consists of a low-pass filter (32) which is connected to the delay equalising circuit (47), and of a high-pass filter (31).

6. Colour television system according to Claim 2, characterised in that the delay equalising circuit (47) is connected to a first input of a logic circuit (38), the output signal of which is supplied to the dematrix circuit (60) and the second input of which is connected to the output of the changeover device (37) located in the luminance channel.

7. Colour television system according to Claim 1, characterised in that in the device for decoding, the high-frequency signal components of the colour television signal (FBAS) and the demodulated low-frequency colour difference signals (U, V; I, Q) are in each case supplied to a first input of an adding circuit (35, 40, 44) and to a first changeover device (51, 52, 53), in that the output of the adding circuit (35, 40, 44) is connected to a first input of a second changeover device (37, 42, 46), in that a field buffer (36, 41, 45) is connected at the output of the first changeover device (51, 52, 53) and in that the output of the field buffer (36, 41, 45) is connected both to a second input of the adding circuit (35, 40, 44) and to a second input of the second changeover device (37, 42, 46).

8. Colour television system according to Claim 1, characterised in that a PAL decoder known per se is used as a device for decoding.

9. Colour television system according to Claim 1, characterised in that a PAL coder, known per se, is used as the device for coding.

10. Colour television system according to Claim 1, characterised in that in the device for coding, the high-frequency luminance signal and/or the chrominance signal is subjected to a filtering in the direction of the horizontal spatial frequency or in the direction of the vertical spatial frequency or in the direction of the temporal frequency and/or combinations thereof.

11. Colour television system according to Claim 1, characterised in that in the device for decoding, the demodulated low-frequency colour difference signals (U, V; I, Q) are subjected to a filtering in the direction of the horizontal spatial frequency or in the direction of the vertical spatial frequency or in the direction of the temporal frequency and/or combinations thereof.

12. Colour television system according to Claim 10 and 11, characterised in that the filtering arrangements in the device for coding and/or in the device for decoding can be disconnected in dependence on the frame repetition rate.

13. Colour television system according to Claim 1, characterised in that a changeover between the device for coding and a PAL coder, known per se, is carried out in dependence on the motion phase between the first and second field, determined by a motion detector.

14. Colour television system according to Claim 13, characterised in that at the transmitting end, a control signal is generated during the changeover which is evaluated at the receiving end.

15. Colour television system according to Claim 1, characterised in that in the device for coding, the high-frequency luminance information is reduced and in that in the device for decoding, the high-frequency luminance information is raised again.


**Revendications**

1. Système de télévision en couleurs comportant un dispositif pour le codage de signaux de télévision en couleurs, qui comprend :
   - un circuit matriciel (1) pour convertir des signaux d'entrée RVB en un signal de luminance (Y) et en au moins deux signaux de différence de couleur (U, V, I, Q),
   - un circuit de filtre (2) et un circuit de compensation de temps de propagation (6) relié à ce circuit de filtre, dans le canal de luminance,
   - un circuit de filtre (3,4) pour les signaux de différence de couleur (U,V,I,Q),
   - un modulateur (5) pour convertir les signaux de différence de couleur (U,V,I,Q) présents à la sortie du circuit de filtre (3,4) en un signal de chrominance, et
   - un circuit additionneur (14) pour réunir le signal de chrominance présent à la sortie du circuit de compensation de temps de propagation (6) et le signal de chrominance pour former le signal de télévision en couleurs (FBAS), et
   comportant un dispositif pour le décodage de signaux de télévision en couleurs, qui comporte :
   - un circuit de filtre (30) pour séparer le signal de télévision en couleurs (FBAS) en des composantes de signal à haute fréquence et à basse fréquence,
   - un démodulateur (33) pour convertir le signal de chrominance en deux signaux de différence de couleur (U,V, I ,Q),
   - un circuit de compensation de temps de propagation (47) disposé dans le canal de luminance, et
   - un circuit de décomposition matricielle (60) pour convertir le signal de luminance (Y) et les deux signaux de différence de couleur (U,V,I,Q) en des signaux de sortie RVB, caractérisé en ce que
   le dispositif de codage est agencé de telle sorte qu'un sous-échantillonnage temporel du signal de chrominance et du signal de luminance à haute fréquence est exécuté de telle sorte que pour les première et seconde trames, respectivement les signaux non modulés de différence de couleur (U,V;I,Q) et le signal de luminance à haute fréquence sont identiques et que le dispositif de décalage est agencé de telle sorte que, pour l'élimination de la perturbation dite cross-colour de première et seconde trames reçues, des composantes à haute fréquence du signal de télévision en couleurs (FBAS), qui contiennent aussi bien le signal de luminance à haute fréquence que le signal de chrominance, sont additionnés et que, pour l'élimination de la perturbation dite cross-colour de première et seconde trames reçues, les signaux de différence de couleur démodulés à basse fréquence (U,V; I,Q) sont additionnés.

2. Système de télévision en couleurs selon la revendication 1, caractérisé en ce que dans le dispositif de codage, le signal de luminance à haute fréquence et les signaux de différence de couleur (U,V;I,Q) sont envoyés respectivement à une mémoire de trames (7,8,9) et à un circuit de commutation (10,11,12), dont l'entrée de commande est reliée à un dispositif de commande (13) et dont l'autre entrée est reliée à la mémoire de trames (7,8, 9).

3. Système de télévision en couleurs selon la revendication 1, caractérisé en ce que dans le dispositif de décodage, les composantes à haute fréquence du signal de télévision en couleurs (FBAS) et les signaux de différence de couleurs démodulés à basse fréquence (U,V;I,Q) sont envoyés respectivement à une mémoire de trames (34,39,43) et à une première entrée d'un circuit additionneur (35,40, 44), dont la seconde entrée est reliée à la sortie de la mémoire de trames (34,39,43), et que la sortie du circuit additionneur (35,30,44) est reliée aussi bien à une autre mémoire de trames (36,41,45) qu'à un dispositif de commutation (37,42,46), dont l'entrée de commande est reliée à un dispositif de commande (50) et dont l'autre entrée est reliée à la seconde mémoire de trames (36,41, 45).

4. Système de télévision en couleurs selon la revendication 1, caractérisé en ce que le circuit de filtre (2) disposé dans le dispositif de codage est constitué par un filtre passe-bas (21), qui est relié au circuit de compensation de temps de propagation (6), et par un filtre passe-haut (22).

5. Système de télévision en couleurs selon la revendication 1, caractérisé en ce que le circuit de filtre (30) disposé dans le dispositif de décodage est constitué par un filtre passe-bas (32), qui est relié au circuit de compensation de temps de propagation (47), et par un filtre passe-haut (31).

6. Système de télévision en couleurs selon la revendication 2, caractérisé en ce que le circuit de compensation de temps de propagation (47) est relié à une première entrée d'un circuit combinatoire (38), dont le signal de sortie est envoyé au circuit (60) de décomposition matricielle (60) et dont la seconde entrée est raccordée à la sortie du dispositif de commutation (37) situé dans le canal de luminance.

7. Système de télévision en couleurs selon la revendication 1, caractérisé en ce que dans le dispositif de décodage, les composantes à haute fréquence du signal de télévision en couleurs (FBAS) et les signaux de différence de couleur démodulés et à basse fréquence (U,V;I,Q) sont envoyés respectivement à une première entrée d'un circuit additionneur (35,40,44) et d'un premier dispositif de commutation (51,52,53), que la sortie du circuit additionneur (35,40,44) est reliée à une première entrée d'un second dispositif de commutation (37,42,46), qu'une mémoire de trames (36,41,47) est raccordée à la sortie du premier dispositif de commutation (51,52,53), et que la sortie de la mémoire de trames (36,41,45) est reliée aussi bien à une seconde entrée du circuit additionneur (35,40, 44) qu'à une seconde entrée du second dispositif de commutation (37,42,46).

8. Système de télévision en couleurs selon la revendication 1, caractérisé en ce qu'on utilise comme dispositif de décodage un décodeur PAL connu en soi.

9. Système de télévision en couleurs selon la revendication 1, caractérisé en ce qu'on utilise comme dispositif de codage un codeur PAL connu en soi.

10. Système de télévision en couleurs selon la revendication 1, caractérisé en ce que dans le dispositif de codage, le signal de luminance à haute fréquence et/ou le signal de chrominance est soumis à un filtrage en direction d'une fréquence locale horizontale ou en direction d'une fréquence locale verticale ou en direction de la fréquence temporelle et/ou de combinaisons de ces fréquences.

11. Système de télévision en couleurs selon la revendication 1, caractérisé en ce que dans le dispositif de décodage, les signaux de différence de couleur démodulés et à basse fréquence (U,V;I,Q) sont soumis à un filtrage en direction d'une fréquence locale horizontale ou en direction d'une fréquence locale verticale ou en direction de la fréquence temporelle et/ou de combinaisons de ces fréquences.

12. Système de télévision en couleurs selon les revendications 10 à 11, caractérisé en ce que les filtrages exécutés dans le dispositif de codage et/ou dans le dispositif de décodage peuvent être interrompus en fonction de la fréquence de répétition d'images.

13. Système de télévision en couleurs selon la revendication 1, caractérisé en ce qu'une inversion de commande entre le dispositif de codage et un codeur PAL connu en soi est exécutée en fonction de la phase de déplacement, déterminée par un détecteur de déplacement, entre des première et seconde trames.

14. Système de télévision en couleurs selon la revendication 13, caractérisé en ce qu'un signal de commande, qui est évalué côté réception, est produit côté émission lors de l'inversion de commande.

15. Système de télévision en couleurs selon la revendication 1, caractérisé en ce que dans le dispositif de codage, une information de luminance à haute fréquence est réduite et que dans le dispositif de décodage, l'information de luminance à haute fréquence est à nouveau accrue.

Fig. 1

Fig. 2

Fig. 3

Signaleingang

Einlesen Bildspeicher

Auslesen Bildspeicher

Signalausgang

# Fig. 4

1.Halbbild

n=

| | | | | |
|---|---|---|---|---|
| 0 | 1 | | 313 | 0 |
| 1 | 2 | | 314 | 1 |
| 2 | 3 | | 315 | 2 |
| 3 | 4 | | 315 | 3 |
| 4 | 5 | | 316 | 4 |
| 310 | 311 | | 623 | 310 |
| 311 | 312 | | 624 | 311 |
| --- | 313 | | 625 | --- |

2.Halbbild

n=

# Fig. 5